# FASCICULE DE BREVET EUROPEEN

(11) **EP 3 060 719 B1**
(45) Date de publication et mention de la délivrance du brevet: **30.01.2019**
(21) Numéro de dépôt: 14786919.2
(22) Date de dépôt: 21.10.2014
(51) Int. Cl.: D21H 11/12, B41M 3/00, D21H 19/38, D21H 19/58, D21H 19/60, H05K 1/03

(54) **PAPIER DESTINÉ EN PARTICULIER À L'IMPRESSION D'UNE COUCHE ÉLECTRO-CONDUCTRICE**
PAPIER, INSBESONDERE ZUM DRUCKEN AUF EINER ELEKTRISCH LEITFÄHIGEN SCHICHT
PAPER ESPECIALLY FOR PRINTING AN ELECTROCONDUCTIVE LAYER

(30) Priorité: 21.10.2013 FR 1360249
(43) Date de publication de la demande: 31.08.2016
(73) Titulaire: Arjo Wiggins Fine Papers Limited, Manchester M1 5ES (GB)
(72) Inventeur: DEPRES, Gaël, F-38850 Chirens (FR)
(74) Mandataire: Desaix, Anne
(86) Numéro de dépôt international: PCT/EP2014/072575
(87) Numéro de publication internationale: WO 2015/059157

(56) Documents cités:
- WO-A1-2011/077048
- FR-A1- 2 985 744
- US-A- 4 157 995
- US-A1- 2001 021 459
- US-A1- 2004 151 886

## Description

La présente invention concerne un papier destiné en particulier à l'impression d'une couche électro-conductrice, ainsi que son procédé de fabrication.

Afin de réaliser un papier selon l'invention, les techniques papetières connues de l'homme du métier peuvent être mises en oeuvre. Un procédé connu consiste à préparer dans un pulpeur une pâte homogène par mélange de fibres cellulosiques et d'eau. Le pulpeur permet le brassage et le cisaillage des fibres, de façon à les séparer et à les individualiser en vue de former une suspension fibreuse.

La pâte passe ensuite au travers d'un raffineur. Ce dernier comporte un stator et un rotor tournant à grande vitesse, équipés de dents ou de stries radiales. La pâte circule entre le rotor et le stator du raffineur de façon à modifier la structure de la paroi des fibres pour introduire de l'eau à l'intérieur des fibres, en vue de couper les fibres et/ou d'augmenter la fibrillation et par conséquent le potentiel de liaison entre les fibres.

La composition de la pâte peut alors être ajustée avant d'être envoyée dans la caisse de tête d'une machine à papier.

La caisse de tête permet de répartir uniformément la pâte sur une toile en mouvement d'une table plate (dans le cas d'une machine Fourdrinier), où elle va subir un égouttage au travers des mailles de la toile, par gravité et par aspiration à l'aide de caisses aspirantes, en vue de réaliser une feuille. Un feutre est généralement appliqué sur la feuille, à l'opposé de la toile. En sortie de la table plate, la feuille contient encore une grande quantité d'eau.

Lors de cette étape, les fibres s'orientent majoritairement dans le sens de déplacement de la toile, appelé sens marche. On définit par sens travers, la direction perpendiculaire au sens marche. En outre, la face de la feuille qui est appliquée contre la toile (côté toile) présente en général une rugosité plus importante que la face opposée (côté feutre).

Il existe également des machines à papier dites à double toile, comportant deux toiles opposées, appliquées de part et d'autre de la feuille. L'eau peut être évacuée par aspiration au travers de chacune des toiles.

Une fois formée la feuille de papier, celle-ci traverse la section de presse de la machine à papier, afin de retirer d'avantage d'eau. Pour cela, la feuille passe entre une série de cylindres compressant la feuille afin d'en extraire de l'eau. Lors de cette étape, la feuille de papier est également prise en sandwich entre des feutres absorbants se présentant sous la forme de ceintures sans fin, des caisses aspirantes permettant de retirer l'eau absorbée par les feutres à l'issue du pressage de la feuille, avant que les feutres ne soient à nouveau appliqués contre la feuille.

La feuille traverse alors une sécherie composée d'une série de cylindres chauffés à la vapeur, sur lesquels passe la feuille. La température des cylindres augmente progressivement, d'amont en aval par rapport au sens de déplacement de la feuille.

On définit par partie humide de la machine à papier, l'ensemble des éléments de la machine (caisse de tête, table plate) situés en amont de la sécherie.

Une fois que l'humidité de la feuille a été fortement réduite, et est par exemple de l'ordre de 5 %, la feuille peut subir un traitement d'encollage en surface par passage au travers d'une presse-encolleuse (« *size press* », en anglais). La presse-encolleuse est généralement formée de deux rouleaux disposés côte-à-côte, de manière à former une cuvette alimentée par une sauce ou un bain d'une composition déterminée. La feuille passe entre les rouleaux de manière à enduire par exemple une ou ses deux faces opposées, avec la sauce pour former une couche.

La feuille passe ensuite dans une section dite de post-sécherie, dans laquelle elle est à nouveau appliquée contre un ou plusieurs rouleaux chauffés à la vapeur.

A l'issue de ces différentes étapes la feuille se présente sous la forme d'une bande continue comportant une zone interne ou à coeur formant un substrat ou matelas fibreux, dont au moins une face ou surface externe est recouverte d'une couche ou enduit.

Cette feuille peut éventuellement subir des opérations de finition telles par exemple que le calandrage ou le lissage, afin d'améliorer l'état de surface de la feuille, avant d'être enroulée, coupée et conditionnée sous la forme de bobines par exemple.

Un papier destiné à l'impression d'une couche électro-conductrice est particulièrement approprié, mais non exclusivement, pour être utilisé dans des applications en électronique, telles par exemple qu'en électronique imprimée (*Printed Electronic*).

L'électronique imprimée consiste à déposer une couche électro-conductrice sur un support souple et flexible, tel qu'un film plastique selon les techniques connues, en vue de la fabrication de composants électroniques tels que des puces électroniques, du type RFID par exemple.

Cependant, bien que les films plastiques (tels que ceux en PEN et en PET) possèdent une faible rugosité de surface qui est particulièrement intéressante pour l'électronique imprimée, ces films plastiques sont peu stables thermiquement et relativement coûteux (le coût de ces films étant supérieur ou égal à 4 euros/m² environ).

La demande de brevet WO 2013/104520, au nom de la Demanderesse, divulgue un procédé de fabrication d'une feuille comportant au moins une couche électro-conductrice, cette feuille comportant un substrat en papier, dont au moins une face est recouverte au moins en partie d'une couche ou de plusieurs couches superposées dont la couche électro-conductrice précitée, le procédé comprenant les étapes consistant à:
a/ préparer ou apporter une structure multicouche comprenant au moins, ou constituée par, un film plastique, un revêtement antiadhésif, et une couche de base, le revêtement antiadhésif étant intercalé entre une face du film plastique et la couche de base,
b/ encoller une face du substrat et/ou la face de la structure multicouche située du côté opposé au film plastique, et appliquer la face précitée du substrat contre la face précitée de la structure multicouche, de façon à contrecoller la structure multicouche et le substrat,
c/ retirer le film plastique et le revêtement antiadhésif de la couche de base, le procédé étant caractérisé en ce que la couche de base est recouverte d'une couche électro-conductrice par une étape supplémentaire consistant à :
d1/ déposer un film électro-conducteur sur la couche de base ; ou
d2/ imprimer la couche de base avec au moins une encre ayant des propriétés électriques, la couche de base étant une couche imprimable à base d'un liant dont le taux est supérieur à 15% en poids sec par rapport au poids total de matière sèche de cette couche, puis éventuellement soumettre la feuille imprimée à un traitement thermique de recuit de façon à former une couche d'encre électro-conductrice.

Au contraire des films plastiques, les papiers et feuilles à base de papier sont plus économiques et ont en outre l'avantage de pouvoir être recyclables et d'être plus stables thermiquement. De plus, l'utilisation de feuilles ou de papiers pour l'électronique imprimée autorise la réalisation de très grandes surfaces imprimées, qui sont plus difficiles à obtenir à partir de films plastiques. Par ailleurs, une feuille ou un papier peut être imprimé pour une application en électronique directement après sa fabrication, c'est-à-dire que la machine d'impression peut être disposée directement après la machine de fabrication du papier, selon un process continu (*roll-to-roll process*)*.* De plus, il est plus facile d'obtenir un papier blanc et brillant qu'un film plastique blanc et brillant car la combinaison des propriétés de blancheur et de brillance est difficile à obtenir avec un film plastique, lequel est d'ailleurs plus difficile à recouvrir avec une composition de couchage en milieu aqueux qu'un papier qui a une nature hydrophile.

L'utilisation du procédé décrit dans la demande de brevet WO 2013/104520 permet de réaliser un support dont au moins une face destinée à être imprimée est très lisse, avec une rugosité Ra comprise par exemple entre 1 et 30 nm, ce qui permet de réaliser une feuille électro-conductrice par impression d'une couche d'encre de très faible épaisseur.

Dans le cas où les encres utilisées sont relativement chères, telles par exemple que des encres utilisant des nanoparticules d'argent, le fait de n'utiliser qu'une très faible couche d'encre permet de réduire de façon importante le coût de réalisation d'une telle feuille électro-conductrice.

Cependant, le procédé précité de réalisation du support en papier est relativement complexe et coûteux. Dans le cas où les encres utilisées ont un coût plus réduit, ou dans le cas où l'on souhaite utiliser des techniques d'impression nécessitant le dépôt d'une couche plus importante, il n'est pas nécessaire d'utiliser un support dont la face destinée à l'impression soit aussi lisse. En effet, dans le cas d'un procédé d'impression par sérigraphie, la couche d'encre déposée est typiquement comprise entre 10 et 15 µm , cette couche étant comprise entre 1 et 3 µm dans le cas d'un procédé d'impression par flexographie. Ainsi, les inventeurs ont déterminé les conditions dans lesquelles un support comportant une face dont la rugosité Ra est par exemple comprise entre 0,1 et 3 µm pourrait suffire à produire des feuilles électro-conductrices de grande qualité.

De plus, le lissé très prononcé conféré par le procédé précité entraine une microporosité du support plus faible, qui influence négativement l'adhésion de l'encre à la surface du support.

Il existe donc un besoin de disposer d'un support, en particulier en papier, permettant l'utilisation des procédés précités d'impression en vue de former une feuille électro-conductrice, et dont la fabrication soit économique.

Par ailleurs, après impression de la couche d'encre, le support ainsi revêtu de la couche d'encre subit en général un traitement de recuit, réalisé par exemple dans un four tunnel ou une étuve et lors duquel le papier et la couche d'encre sont soumis à une température importante pendant une période donnée.

A titre d'exemple, la demande de brevet US 2009/0242019 décrit la réalisation de cellules solaires par un dépôt de silane sur un support plastique flexible, un recuit à une température comprise entre 250 et 400°C permettant de transformer le silane en silicium polycristallin.

On notera qu'un tel support plastique a une résistance thermique relativement faible (à l'exception de certains plastiques coûteux tels que le polyimide), par comparaison à un support en papier.

L'utilisation d'un papier pour la réalisation d'un produit électro-conducteur sous la forme d'une feuille présente les inconvénients suivants.

Dans le cas où l'on utilise un support en papier non couché, sur lequel une couche électro-conductrice est réalisée par impression, on remarque que la conductivité des pistes réalisées est relativement faible. Ceci peut s'expliquer par la rugosité et la porosité très importantes du support, qui provoquent une discontinuité dans les pistes électro-conductrices. A titre d'exemple, la résistance des pistes conductrices imprimées par flexographie avec des encres contenant des nanoparticules d'argent, avec un recuit à 180°C pendant 5 minutes, sur un papier de type Bristol® fabriqué par la société Arjowiggins Creative Papers, est de l'ordre de 3100 Ω/sq. On rappelle que, plus cette résistance est élevée, plus la conductivité de la piste conductrice est faible.

A l'inverse, les papiers couchés ont des couches pigmentaires liées avec un latex synthétique, de sorte que leur porosité et leur rugosité en surface soient plus faibles. Si l'on imprime ces papiers couchés avec des encres conductrices, on constate là encore que la conductivité des pistes obtenues est moyenne, car on ne peut pas effectuer de recuit à haute température. En effet, de tels papiers couchés ont une mauvaise stabilité dimensionnelle (déformations ou retraits dimensionnels lors d'un recuit à haute température). A titre d'exemple, la résistance des pistes conductrices imprimées par flexographie avec des encres contenant des nanoparticules d'argent, avec un recuit à 180°C pendant 5 minutes, sur un papier de type Sensation® fabriqué par la société Arjowiggins Creative Papers, est de l'ordre de 1700 Ω/sq.

Par ailleurs, on remarque que de tels papiers jaunissent à partir de 140°C.

Il existe donc un besoin de disposer d'un papier pouvant servir de support à une couche d'encre électro-conductrice déposée par impression notamment, et qui soit à la fois peu couteux à produire, résistant thermiquement (peu de déformation ou de retrait dimensionnel à haute température, peu d'effet de jaunissement) et permettant de réaliser des pistes conductrices ayant une bonne conductivité (du fait notamment de la relativement faible porosité et/ou de la faible rugosité de la surface du papier qui est destinée à l'impression).

L'invention a notamment pour but d'apporter une solution simple, efficace et économique à ce problème.

A cet effet, elle propose un papier comportant un substrat fibreux comprenant au moins une face recouverte d'au moins une couche, ladite couche comprenant ou consistant en :
- 100 parts en poids sec de pigments,
- de 5 à 50 parts en poids sec d'un ou plusieurs liants acryliques dont la température de transition vitreuse est inférieure ou égale à 20°C, de préférence inférieure ou égale à 10°C,
- de 0 à 15 parts en poids sec d'agent viscosant, tel par exemple que de l'alcool polyvinylique,
caractérisé en ce que le substrat fibreux comporte de 70 à 90 % en poids sec de fibres cellulosiques courtes, de longueur moyenne comprise dans un intervalle de 0,5 à 1,5 mm, telles que des fibres de bois, en particulier des fibres de bois issues d'une pâte chimique blanchie d'eucalyptus et 10 à 30 % en poids d'au moins une charge minérale, de préférence du carbonate de calcium, du kaolin ou du dioxyde de titane.

La couche peut recouvrir l'une seulement des deux faces du substrat, ou encore les deux faces dudit substrat. La couche peut couvrir la totalité de la face concernée ou au contraire peut couvrir une zone délimitée de surface inférieure à la surface de chaque face du substrat.

Selon un mode de réalisation particulier de l'invention, le substrat fibreux est recouvert, en tout ou partie, avec une unique couche et cette couche est telle que définie ci-dessus.

L'utilisation de liants résistants à la température permet d'améliorer la résistance thermique du papier lors d'une éventuelle étape de recuit thermique, c'est-à-dire de réduire les déformations ou le retrait dimensionnel ainsi que l'effet du jaunissement se produisant lors d'une telle étape de recuit.

Dans un mode de réalisation particulier de l'invention, le liant ou les liants de la couche déposée en surface du substrat et destinée à l'impression, est un liant acrylique composé d'ester acrylique et d'acrylonitrile dont la température de transition vitreuse est inférieure à 10°C. A titre d'exemple le liant comprend ou est constitué par l'Acronal LN579S commercialisé par la société BASF.

Bien qu'il soit classiquement admis qu'un liant ayant une température de transition vitreuse élevée est plus résistant thermiquement, la Demanderesse a constaté de façon surprenante que, au contraire, l'utilisation d'un liant ayant une température de transition vitreuse faible, en particulier inférieure ou égale à 20°C, de préférence inférieure ou égale à 10°C, permet d'améliorer considérablement la résistance thermique du papier, en particulier en termes de déformation. Ceci est illustré aux exemples 1 et 2 ci-après.

Ladite couche peut comporter de 10 à 30 parts en poids sec de liant dont la température de transition vitreuse est inférieure ou égale à 20°C, préférentiellement de 15 à 25 parts en poids sec, encore plus préférentiellement 19 parts en poids sec. Préférentiellement, on utilise un liant acrylique.

Dans un mode de réalisation particulier, ladite couche peut comporter 0,05 à 15 parts en poids sec d'agent viscosant, plus préférentiellement 0,05 à 5 parts en poids sec, et encore plus préférentiellement 0,05 à 4 parts en poids sec d'un tel agent.

En particulier, ladite couche peut comporter de 5 à 10 parts en poids sec d'alcool polyvinylique utilisé comme agent viscosant, plus préférentiellement 8 parts en poids sec.

D'autres agents viscosants peuvent être utilisés parmi lesquels on citera : l'alcool polyvinylique (PVA), le carboxyméthylcellulose (CMC), l'hydroxyméthylcellulose (HMC), un copolymère acrylique, une gélatine, un alginate, une protéine de soja, un galactomannane, une nanocellulose, un polysaccharide, polyacrylate réticulé, un polyvinylpyrrolidone, un uréthane éthoxylé hydrophobique, une émulsion hydrophobique gonflable en milieu alkalin.

A titre d'exemple, ladite couche peut comporter de 0,05 à 1 part en poids sec de carboxyméthyl cellulose, ou d'hydroxyméthyl cellulose, utilisé comme agent viscosant.

On choisira le type d'agent viscosant en fonction de procédé de couchage utilisé. De manière générale, plus la quantité d'agent(s) viscosant(s) est importante, moins la couche résiste aux hautes températures.

Le substrat comporte de 70 à 90 % en poids sec de fibres cellulosiques courtes, de longueur moyenne comprise dans un intervalle de 0,5 à 1,5 mm, telles que des fibres de bois, en particulier des fibres de bois issues d'eucalyptus.

L'utilisation de fibres courtes permet d'améliorer la résistance thermique du papier en ce qui concerne la déformation ou le retrait dimensionnel du papier. Un tel avantage est illustré à l'exemple 3.

Par ailleurs, il a été constaté que l'utilisation de fibres comportant un faible taux de lignine, telles que des fibres de bois issues d'une pâte chimique blanchie d'eucalyptus, qui sont également des fibres courtes, permet d'améliorer la résistance thermique du papier (en particulier du substrat) en termes de jaunissement en cas d'exposition à de fortes températures. Cela est illustré à l'exemple 4.

De préférence, le substrat comporte 80 % en poids sec de fibres cellulosiques courtes, ou plus.

Dans un mode de réalisation particulier de l'invention, le substrat est obtenu à partir d'une pâte fibreuse dont le taux de raffinage est inférieur à 50°SR, ou inférieur à 40°SR, de préférence inférieur à 35°SR.

En outre, le substrat fibreux comporte de 10 à 30 % d'au moins une charge minérale, par exemple du carbonate de calcium, du kaolin ou du dioxyde de titane.

Le carbonate de calcium, ou toute autre charge minérale, permet de réduire les liaisons inter-fibres et donc d'améliorer la stabilité dimensionnelle.

Avantageusement, le papier a une blancheur comprise entre 70 et 90, de préférence comprise entre 75 à 85, de façon à réduire l'effet de jaunissement du papier. Ceci correspond à une teinte crème.

La blancheur est mesurée selon la norme ISO 2470.

En effet, la Demanderesse a démontré que la différence de teinte du papier après une étape de recuit, par comparaison avec le même papier avant recuit, est dépendante de la couleur du papier avant recuit. Ainsi, plus le papier avant recuit est blanc, plus l'effet de jaunissement à haute température est visible. Ainsi, le jaunissement d'un papier de couleur crème, vanille ou ivoire est beaucoup moins visible que dans le cas d'un papier blanc. Ceci est illustré à l'exemple 5.

Avantageusement, la différence de teinte ΔE du papier calculée à partir des coordonnées CIE LAB du papier, après un recuit à 200°C pendant 5 minutes, est inférieure à 5, de préférence inférieure à 2, par rapport audit papier avant recuit.

On notera qu'un écart de teinte inférieur ou égal à 1 n'est pas visible à l'oeil nu pour une personne avertie. Un écart de teinte inférieur ou égal à 5 est relativement faible. On garantit ainsi que l'étape de recuit a peu d'influence sur la couleur du papier.

Par ailleurs, la couche recouvrant le substrat du papier selon l'invention ne comporte pas ou très peu d'azurants optiques, c'est-à-dire moins de 0,5 parts en poids sec pour 100 parts en poids sec de pigments, de préférence moins de 0,1 parts en poids sec pour 100 parts en poids sec de pigments.

Des azurants optiques sont utilisés dans l'art antérieur afin d'augmenter la blancheur du papier. Si de tels azurants optiques permettent d'augmenter la blancheur à de faibles températures, ils sont cependant détruits lorsqu'ils sont exposés à des températures importantes, en particulier lors d'une étape de recuit. La différence de teinte qui en résulte, à l'issue d'une telle étape de recuit, est par conséquent d'autant plus importante que la quantité d'azurants optiques est importante.

En outre, la couche recouvrant au moins une face peut être imprimée sur tout ou partie de la surface de ladite couche avec une épaisseur d'encre électro-conductrice de 0,1 à 20 µm, en particulier de 0,5 à 15 µm, et de 0,1 à 3 µm ou de 10 à 15 µm dans un mode de réalisation particulier.

Comme vu précédemment, cette impression peut être réalisée par sérigraphie, par flexographie ou par héliographie.

Une encre électro-conductrice est une encre comportant des éléments conducteurs tels que des nanoparticules et/ou des molécules, ces éléments conférant au papier imprimé avec l'encre (et éventuellement soumis à une étape de recuit) une conductivité électrique.

Le papier selon l'invention peut être utilisé pour plusieurs types d'application dans le domaine de l'électronique imprimée, dont six ressortent principalement :
- les circuits imprimés comportant des pistes conductrices, des résistances, des capacités et des transistors ;
- les cellules photovoltaïques ;
- les écrans (électrochromes ou LCD) ;
- les claviers à membrane ; la feuille peut alors comprendre un composant ou être soumise à un traitement particulier pour la rendre ignifuge, la feuille peut par exemple comprendre des retardateurs de flamme de type trihydroxyde d'aluminium, par exemple du BACO FRF40® de la société Alcan Chemicals (des valeurs de 30 % de BACO FRF40® dans la masse de la feuille peuvent permettre d'obtenir un classement au feu M1 ou M2) ; on peut aussi rajouter des produits en *size press,* de type sels de phosphore/ammonium avec des taux de 50 % par rapport à l'amidon ; d'autres produits peuvent également être utiliser, par exemple à base de polyphosphate d'ammonium, de trioxyde d'antimoine, de sulfamate d'ammonium, etc. ;
- les OLEDs (diodes électroluminescentes organiques) sont des diodes électroluminescentes dont le matériau émetteur est un matériau organique ; lorsque ce matériau est traversé par un courant, il devient source de lumière ;
- les membranes « Switch » (ou commutateur à membrane) permettent de faire une connexion momentanée par contact ; de l'encre conductrice est déposée sur un support flexible de type polyester ou polycarbonate ; un dôme se forme et constitue l'élément actif d'un bouton ; sous l'effet d'une pression, le dôme se déforme et ferme le circuit ; cette technologie est utilisée dans les téléphones portables, les appareils photos, les tableaux de commande, les jouets, etc. ; et
- les étiquettes RFID (*Radio Frequency IDentification*), également appelées étiquettes intelligentes ou étiquettes à puces ou tag ou transpondeur sont des équipements destinés à recevoir un signal radio et à renvoyer en réponse un signal radio différent, contenant une information.

L'invention concerne donc un objet ou produit fabriqué avec un papier imprimé électro-conducteur selon l'invention, tel qu'un objet choisi dans la liste ci-dessus.

L'invention concerne également un procédé de fabrication d'un papier du type précité, caractérisé en ce qu'il comporte les étapes consistant à :
- former un substrat fibreux à l'aide d'une pâte fibreuse,
- recouvrir, au moins en partie, au moins une surface du substrat fibreux par couchage avec une couche comportant 100 parts en poids sec de pigments, de 5 à 50 parts en poids sec d'un ou plusieurs liants acryliques dont la température de transition vitreuse est inférieure ou égale à 20°C, de préférence est inférieure ou égale à 10°C, et de 0 à 15 parts en poids sec d'un agent viscosant, de préférence 0,05 à 15 parts d'un agent viscosant, par exemple d'alcool polyvinylique,
caractérisé en ce que le substrat fibreux comporte de 70 à 90 % en poids sec de fibres cellulosiques courtes, de longueur moyenne comprise dans un intervalle de 0,5 à 1,5 mm, telles que des fibres de bois, en particulier des fibres de bois issues d'une pâte chimique blanchie d'eucalyptus et 10 à 30 % en poids d'au moins une charge minérale, de préférence du carbonate de calcium, du kaolin ou du dioxyde de titane.

Le procédé de couchage se réfère, comme il est généralement admis dans le domaine de la papèterie, à un procédé de dépôt direct d'une couche (ou d'enduction) se trouvant en milieu aqueux. On peut citer comme exemples de procédés de dépôt de couche en milieu aqueux, les procédés de dépôt par presse encolleuse et par lame d'air. Au contraire du procédé proposé par le document WO 2013/104520, les procédés de couchage utilisés dans le cadre de l'invention n'impliquent pas de transfert de la couche à l'état sec d'un support tiers au substrat.

De préférence, le taux de raffinage de la pâte fibreuse est inférieur à 50°SR, de préférence inférieur à 40°SR, encore plus préférentiellement de l'ordre de 35°SR. On notera que, pour des questions de mise en oeuvre du procédé de fabrication, on préferera tout de même que le taux de raffinage soit supérieur ou égal à 20°SR.

La Demanderesse a également démontré que le taux de raffinage de la pâte fibreuse a une influence sur la stabilité dimensionnelle du papier. En effet, il a été constaté que plus le taux de raffinage est faible, moins le papier aura tendance à se déformer. Ce phénomène est illustré à l'exemple 6.

On notera que la mesure du taux de raffinage, exprimé en degré Schopper-Riegler, est réalisée suivant la norme ISO 5267-1 :1999. Ce taux représente la quantité d'eau en centilitres égouttée à travers un gâteau de pâte et s'écoulant par un déversoir. C'est un indice d'égouttage permettant de mesurer la vitesse à laquelle l'eau peut être extraite d'une suspension de pâte diluée.

De préférence, ladite couche recouvrant en tout ou partie le substrat fibreux est appliquée par couchage, à l'aide d'une presse encolleuse d'une machine à papier par exemple, ce qui permet de réduire les coûts de fabrication d'un tel papier.

L'invention concerne également un procédé de fabrication d'un produit électro-conducteur, comportant les étapes consistant à :
- recouvrir par impression à l'aide d'une encre électro-conductrice, au moins une zone d'un support réalisé à partir d'un papier du type précité,
- réaliser un recuit du support et de l'encre de façon à former une couche ou une piste continue électro-conductrice sur le support.

Dans un mode de réalisation particulier, l'impression au moyen de l'encre électro-conductrice est réalisée par flexographie ou sérigraphie.

L'invention a aussi pour objet un papier tel qu'obtenu par le susdit procédé. Le papier selon l'invention ou tel qu'obtenu par ce procédé est apte à recevoir et fixer de façon stable une encre électro-conductrice en raison de son état de surface, montrant une porosité de surface faible mais suffisante pour permettre à l'encre de pénétrer la surface du papier. Ainsi, la porosité de surface d'un papier selon l'invention a, dans un test Microcontour tel que celui décrit dans l'exemple 8, une valeur de densité optique supérieure à 0 (à une longueur d'onde entre 380 et 780 nm) et en particulier, une valeur de densité optique dans un intervalle de 0,2 à 1 ou en particulier de 0,2 à 0,8.

La durée du recuit peut être comprise dans un intervalle de moins d'une seconde à plusieurs minutes, la température du recuit pouvant être comprise dans un intervalle de 100 à 300°C, de préférence de 180°C à 220°C.

En outre, la couche d'encre déposée par impression sur le support peut être comprise dans un intervalle de 0,5 à 15 µm, de préférence de 1 à 10 µm.

De plus, l'encre électro-conductrice peut être déposée par un procédé d'impression de type sérigraphie, flexographie ou héliographie.

Par ailleurs, l'invention concerne également un papier comprenant un substrat fibreux comportant une face recouverte d'une couche sur laquelle est imprimée une encre électro-conductrice, tel qu'obtenu au moyen d'étapes consistant à
- former un substrat fibreux à l'aide d'une pâte fibreuse,
- recouvrir, au moins en partie, au moins une surface du substrat fibreux par couchage avec une couche comportant 100 parts en poids sec de pigments, de 5 à 50 parts en poids sec d'un ou plusieurs liants acryliques dont la température de transition vitreuse est inférieure ou égale à 20°C, de préférence est inférieure ou égale à 10°C, et de 0 à 15 parts en poids sec d'un agent viscosant,
- recouvrir par impression à l'aide d'une encre électro-conductrice, au moins une zone de la couche,
- réaliser un recuit du substrat couché et de l'encre de façon à former une couche ou une piste continue électro-conductrice sur le support, caractérisé en ce que le substrat fibreux comporte de 70 à 90 % en poids sec de fibres cellulosiques courtes, de longueur moyenne comprise dans un intervalle de 0,5 à 1,5 mm, telles que des fibres de bois, en particulier des fibres de bois issues d'une pâte chimique blanchie d'eucalyptus et 10 à 30 % en poids d'au moins une charge minérale, de préférence du carbonate de calcium, du kaolin ou du dioxyde de titane.

L'invention est illustrée et d'autres détails, caractéristiques et avantages de l'invention apparaîtront à la lecture de la description suivante qui comprend des exemples de mise en oeuvre de l'invention, en référence aux figures dans lesquelles :
- la figure 1 est un diagramme représentant le taux d'humidité en fonction du temps, lors d'un cycle d'humidité,
- la figure 2 comporte un premier diagramme représentant la déformation résiduelle d'une feuille de papier à l'issu d'un cycle d'humidité, pour quatre types de fibres différents, et un second diagramme représentant l'amplitude totale de la déformation du papier lors dudit cycle d'humidité, pour les quatre types de fibres,
- la figure 3 est un diagramme illustrant la perte de blancheur ou l'écart de teinte ΔE après recuit, pour quatre types de fibres différents,
- la figure 4 est un diagramme illustrant, pour quatre papiers de couleurs différentes, l'écart de teinte ΔE obtenu après recuit,
- la figure 5 est un diagramme illustrant, pour différents taux de raffinage, la déformation résiduelle et l'amplitude totale de la déformation du papier lors d'un cycle d'humidité.

Exemple 1 : Mise en évidence de l'influence du type de liant sur la résistance thermique du papier, en particulier sur le jaunissement du papier.

Dans cet exemple, on réalise plusieurs papiers comprenant chacun un substrat comportant des fibres cellulosiques de bois issues d'eucalyptus, connues sous la référence Cenibra®, recouvert d'une couche comportant notamment des pigments et un liant. Pour ces différents papiers, on fait varier le type de liant utilisé dans la couche et on mesure, pour chaque type de liant utilisé, la blancheur rémanente du papier couché ainsi obtenu après un recuit de 5 minutes à 220°C.

La blancheur rémanente est le rapport de la blancheur mesurée après recuit par rapport à la blancheur mesurée avant recuit, exprimée en pourcentage. Les blancheurs précitées sont mesurées par la norme ISO 2470.

Pour chaque liant est indiqué sa dénomination commerciale, le type de liant, la température de transition vitreuse Tg dudit liant et la blancheur rémanente mesurée après recuit.

Les résultats obtenus sont les suivants :
- Liant 1 : Styronal D 517; styrène-butadiène ; Tg=0°C ; Blancheur rémanente mesurée : 19%
- Liant 2 : Acronal S 305 D ; butyl-acrylate et styrène ; Tg=25°C ; Blancheur rémanente mesurée : 55 %
- Liant 3 : PVA BF 17 H ; alcool polyvinylique ; Blancheur rémanente mesurée : 45 %
- Liant 4 : Acronal S 728 ; butyl-acrylate et styrène ; Tg=25°C ; Blancheur rémanente mesurée : 49 %
- Liant 5 : Acronal LN 579 S ; ester acrylique et acrylonitrile ; Tg=7°C ; Blancheur rémanente mesurée : 61 %
- Liant 6 : Acronal S 888 S ; ester acrylique, styrène et acrylonitrile ; Tg=31°C ; Blancheur rémanente mesurée : 47 %
- Liant 7 : Acronal DS 2416 ; ester acrylique et styrène ; Tg=38°C ; Blancheur rémanente mesurée : 72 %
- Liant 8 : Acronal S 996 S ; ester acrylique et styrène ; Tg=46°C ; Blancheur rémanente mesurée : 62 %
- Liant 9 : Esacote PU 21/S ; polyuréthane aliphatique ; Blancheur rémanente mesurée : 33 %

On remarque que les liants offrant la meilleure résistance thermique au jaunissement, c'est-à-dire la meilleure blancheur rémanente après recuit, sont les liants de type acrylique ou ester acrylique, tels par exemple que les liants référencés 5, 7 et 8.

Exemple 2 : Mise en évidence de l'influence de la température de transition vitreuse Tg d'un liant sur la résistance thermique du papier, en particulier sur la déformation du papier hors du plan de la feuille de papier.

L'amplitude de ces déformations a été mesurée par analyse d'images en utilisant une méthode de triangulation à l'aide de deux caméras CCD, les mesures ayant été réalisées 60 minutes après le recuit. Une telle méthode de mesure par analyse d'images est connue de l'article « Stereo Image Corrélation for full-field measurement on composite femoral bones during compression tests », Remi Billard et al, publié le 21 mars 2012.

Dans cet exemple, on réalise plusieurs papiers comprenant chacun un substrat comportant des fibres cellulosiques de bois issues d'eucalyptus, connues sous la référence Cenibra®,, recouvert d'une couche comportant notamment des pigments et un liant. Pour ces différents papiers, on fait varier le type de liant utilisé dans la couche et on mesure, pour chaque type de liant utilisé, la déformation de la feuille de papier hors du plan de la feuille. Plus particulièrement, pour cet exemple comparatif, on utilise un liant de type Acronal LN 579 S (ester acrylique et acrylonitrile) dont la température de transition vitreuse Tg est de 7°C (liant 6 dans l'exemple 1), et un liant de type Acronal S728 (butyl-acrylate et styrène) dont la température de transition vitreuse Tg est de 25°C (liant 4 dans l'exemple 1). Le papier ainsi obtenu subit une étape de recuit à 120 °C pendant 10 minutes.

On obtient une déformation hors du plan de 15 mm pour le liant 6, dont la température de transition vitreuse Tg est de 7°C, et une déformation hors du plan de 35 mm pour le liant 4, dont la température de transition vitreuse Tg est de 25°C.

On remarque ainsi que, plus la température de transition vitreuse du liant est basse, plus la résistance thermique du papier en termes de déformation est élevée.

Exemple 3 : Mise en évidence de l'influence du type de fibres sur la déformation dudit papier.

Dans cet exemple, on réalise plusieurs papiers comportant chacun un substrat fibreux, recouvert d'une couche comportant notamment des pigments et un liant. Pour ces différents papiers, on fait varier le type de fibres utilisé dans le substrat et on mesure, pour chaque type de fibres utilisé, la déformation résiduelle de la feuille de papier ainsi réalisée après un cycle d'humidité décrit après, ainsi que l'amplitude totale de la déformation de ladite feuille lors d'un tel cycle. On mesure en particulier la déformation dans le plan de la feuille de papier.

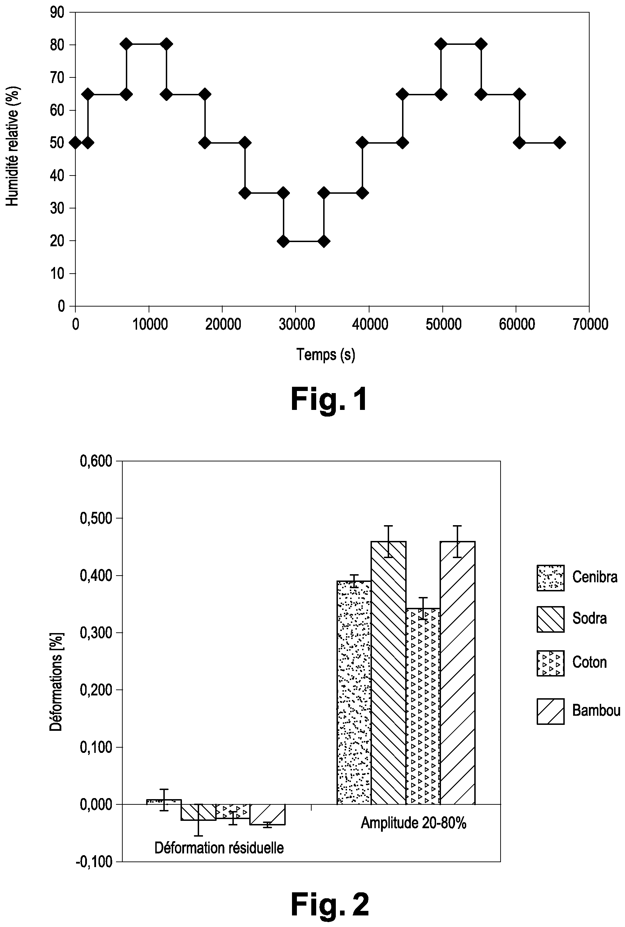

Pour la mesure de ces déformations, un appareil de type Varidim a été utilisé. En outre, lors d'un cycle d'humidité, on fait varier le taux d'humidité relative de la feuille de papier dans le temps, selon une loi illustrée sur le diagramme de la Figure 1. Ce diagramme représente l'humidité relative de la feuille, exprimée en pourcents, par rapport au temps, exprimé en secondes. On remarque que, lors d'un cycle, l'humidité relative de départ est de 50 %, augmente progressivement jusqu'à 80 % avant de diminuer à 20%, puis augmente à nouveau progressivement jusqu'à 80% avant d'être encore abaissée progressivement jusqu'à 50%.

La Figure 2 comporte deux diagrammes, dont un premier diagramme représente la déformation résiduelle de la feuille de papier à l'issu d'un cycle d'humidité, pour quatre type de fibres différentes, à savoir :
- Fibres A : des fibres cellulosiques courtes de bois issues d'une pâte chimique blanchie d'eucalyptus, connues sous la référence Cenibra®, de longueur moyenne comprise dans l'intervalle de 0,5 à 1,5 mm,
- Fibres B : des fibres cellulosiques longues de bois issues de résineux, connues sous la référence Sodra®, de longueur moyenne comprise dans l'intervalle de 1,5 à 3 mm,
- Fibres C : des fibres courtes de coton, de longueur moyenne comprise dans l'intervalle de 0,5 à 2 mm,
- Fibres D : des fibres longues de bambou, de longueur moyenne comprise dans l'intervalle de 0,8 à 1,8 mm.

Le second diagramme représente l'amplitude totale de la déformation du papier, dans le plan de la feuille et lors d'un cycle d'humidité, pour chacun des types de fibres A à D précité.

On constate que l'utilisation de fibres courtes (Cenibra®, coton) permet de réduire les déformations totale et résiduelle du papier soumis à un cycle d'humidité, par comparaison avec un substrat comportant des fibres longues (Sodra®, bambou).

Exemple 4 : Mise en évidence de l'influence du type de fibres sur le jaunissement du papier.

Dans cet exemple, on réalise plusieurs papiers comprenant chacun un substrat fibreux recouvert d'une couche comportant notamment des pigments et un liant. Pour ces différents papiers, on fait varier le type de fibres utilisé dans le substrat et on mesure, pour chaque type de fibres utilisé, les écarts de teinte du papier entre le papier obtenu après recuit par rapport au même papier avant recuit. Le papier avant recuit est de couleur blanche.

Plus particulièrement, le recuit est réalisé dans une étuve, à une température de 200°C pendant 5 minutes. L'écart de teinte, également appelé perte de blancheur, est généralement noté ΔE et est calculé à partir des coordonnées CIE LAB du papier à partir de la formule suivante ΔE = (L² + A² + B²)^{0,5}, comme cela est bien connu en soi.

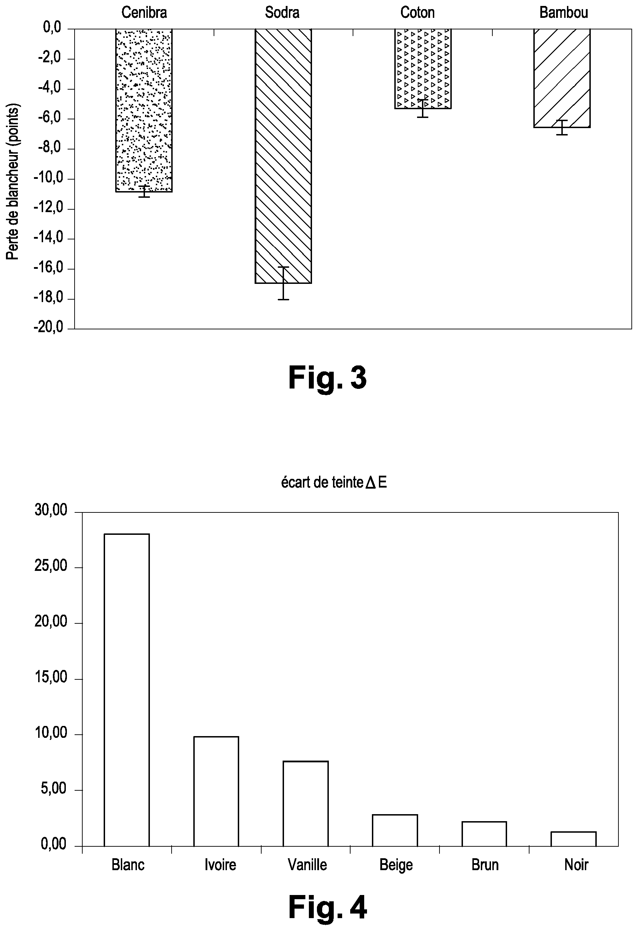

La figure 3 est un diagramme illustrant la perte de blancheur ou écart de teinte ΔE, pour quatre types de fibres différents, à savoir :
- Fibres A : des fibres cellulosiques courtes de bois issues d'une pâte chimique blanchie d'eucalyptus, connues sous la référence Cenibra®, de longueur moyenne comprise dans l'intervalle de 0,5 à 1,5 mm,
- Fibres B : des fibres cellulosiques longues de bois issues de résineux, connues sous la référence Sodra®, de longueur moyenne comprise dans l'intervalle de 1,5 à 3 mm,
- Fibres C : des fibres courtes de coton, de longueur moyenne comprise dans l'intervalle de 0,5 à 2 mm,
- Fibres D : des fibres longues de bambou, de longueur moyenne comprise dans l'intervalle de 0,8 à 1,8 mm.

On constate que cet écart de teinte est d'autant plus réduit que le taux de lignine des fibres est faible. En particulier, cet écart de teinte est relativement faible pour les fibres de coton, pour les fibres de bambou et pour les fibres de bois issues d'eucalyptus (Cenibra®). Au contraire, cet écart de teinte est relativement important pour des fibres de bois issues de résineux (Sodra®).

Exemple 5 : Mise en évidence de l'influence de la couleur du substrat avant recuit sur le jaunissement du papier après recuit.

Dans cet exemple, on réalise différents papiers comprenant chacun un substrat fibreux recouvert d'une couche comportant notamment des pigments et un liant. Pour ces différents papiers, on fait varier la couleur du substrat (et donc du papier) par adjonction d'un colorant dans la pâte, par exemple dans le pulpeur, lors de la fabrication du papier. En particulier, cet exemple comporte six papiers de teintes différentes, avant recuit, respectivement des papiers blanc, ivoire, vanille, beige, brun et noir. Les couleurs précitées sont listées dans l'ordre inverse de leur blancheur.

Ces différents papiers subissent ensuite une étape de recuit à 220°C pendant 5 minutes.

La Figure 4 est un diagramme illustrant, pour chaque papier, l'écart de teinte ΔE obtenu après recuit, par comparaison avec le même papier avant recuit. On constate que l'écart de teinte est très important pour un papier dont la couleur de départ (c'est-à-dire avant recuit) est la couleur blanche et que cet écart de teinte est quasiment nul pour un papier dont la couleur de départ est la couleur noire, l'écart de teinte variant progressivement d'un extrême à l'autre en fonction de la couleur de départ du papier.

Exemple 6 : Mise en évidence de l'influence taux de raffinage (mesuré en degré Schopper-Riegler ou °SR) de la pâte fibreuse sur la déformation dudit papier.

Dans cet exemple, on réalise plusieurs papiers comprenant chacun un substrat fibreux, recouvert d'une couche comportant notamment des pigments et un liant. En particulier, le substrat comporte un taux de charges de 15%.

Pour ces différents papiers, on fait varier le taux de raffinage (mesuré en degrés Schopper-Riegler, noté °SR) de la pâte fibreuse et on mesure, pour chaque papier, la déformation résiduelle de la feuille de papier ainsi obtenue après un cycle d'humidité identique à celui décrit ci-dessus en référence à la figure 1. On mesure également l'amplitude totale de la déformation de la feuille lors d'un cycle. Ces déformations correspondent aux déformations de la feuille de papier dans son plan. Comme précédemment, pour la mesure de ces déformations, un appareil de type Varidim a été utilisé.

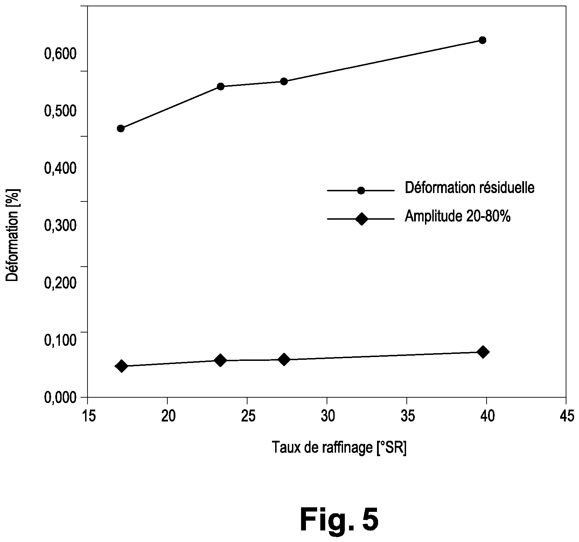

La Figure 5 est un diagramme illustrant, pour chaque papier, et donc pour différents taux de raffinage, ladite déformation résiduelle (Courbe C1) et ladite amplitude totale de la déformation (Courbe C2). On constate que ces déformations sont d'autant plus faibles que le taux de raffinage est faible.

De même, l'influence du taux de raffinage sur la déformation de la feuille du papier hors de son plan a été étudiée.

Pour cela, deux papiers ont été préparés, l'un réalisé à partir d'une pâte fibreuse dont le taux de raffinage est de 40°SR et l'un réalisé à partir d'une pâte fibreuse dont le taux de raffinage est de 35°SR. Les déformations ont été mesurées à l'aide de la méthode d'analyse d'images par triangulation décrite précédemment.

Il a été constaté que la déformation hors du plan pour le papier préparé à partir d'une pâte ayant un taux de raffinage de 40°SR est de 4,8 mm alors qu'elle n'est que de 3,2 mm pour le papier préparé à partir d'une pâte ayant un taux de raffinage de 35°SR.

On constate par conséquent que de telles déformations sont d'autant plus faibles que le taux de raffinage de la pâte utilisée est faible.

Exemple 7 : Exemple de réalisation d'un papier selon une forme de réalisation de l'invention.

Selon cette forme de réalisation, une pâte fibreuse homogène est préparée dans un pulpeur. La pâte comporte de l'eau, un colorant jaune (dont la part en poids sec est négligeable) permettant d'obtenir une teinte crème du substrat, environ 80% en poids sec de fibres de cellulose de bois issues d'eucalyptus de type Cenibra® et environ 20% en poids sec de carbonate de calcium (CaCO3) connu sous la référence Omyacarb®.

La pâte passe ensuite au travers d'un raffineur où son taux de raffinage est ajusté à 35°SR environ.

La composition de la pâte est ensuite ajustée dans la caisse de tête d'une machine à papier, en y ajoutant un amidon cationique de type Hicat 1134A, dans une proportion de 1% en poids par rapport au taux de matière sèche dans la pâte.

Comme indiqué précédemment, la caisse de tête permet de répartir uniformément la pâte sur une toile où une feuille est formée avant de traverser la section de presse puis la sécherie de la machine à papier.

La feuille subit alors un traitement d'encollage en surface par passage au travers d'une presse-encolleuse, de façon à former au moins une couche. Lors de cette étape, la feuille traverse un bain dont la composition est résumée dans le tableau suivant :

| Produit utilisé | Référence | Parts en poids sec |
|---|---|---|
| Eau | | 0 |
| Pigment type Kaolin | Capim® RG | 70 |
| Pigment type CaCO3 | Carbital® 95 | 30 |
| Total Pigment | | 100 |
| Antimousse | Nopcomaster® MPE 847 | 0,1 |
| Réticulant | Cartabond® MZI | 0,5 |
| Soude | | 1 |
| Latex | Acronal® LN579S | 19 |
| PVA | Mowiol® 4-98 | 8 |

La feuille passe ensuite dans une section dite de post-sécherie,

A l'issue de ces différentes étapes la feuille se présente sous la forme d'une bande continue comportant une zone interne ou à coeur formant un substrat ou un matelas fibreux, dont la composition est définie par la pâte fibreuse et dont au moins une surface externe est recouverte d'une couche dont la composition est définie par le bain de la presse encolleuse.

Cette feuille de papier peut éventuellement subir des opérations de finition.

Un tel papier a une porosité de surface relativement faible, un jaunissement très faible en cas de recuit (un ΔE inférieur à 3 pour un recuit de 5 minutes à 180°C), un retrait dimensionnel très faible (inférieur à 0,25 % pour un recuit de 5 minutes à 180°C) et permet d'obtenir une conductivité thermique élevée des pistes électro-conductrices imprimées.

A titre d'exemple, le tableau ci-dessous présente des exemples comparatifs entre un tel papier selon l'invention et d'autres papiers du commerce, respectivement un papier adapté à l'impression de photographie (appelé ci-après papier photo), un papier couché commercialisé par la société Arjowiggins Creative Paper sous la référence Sensation®, et un papier couché brillant commercialisé par la société Arjowiggins Creative Paper sous la référence Main Gloss®

Ces exemples comparatifs présentent les valeurs des écarts de teinte ΔE pour différentes températures et pour différentes durées de recuit. Les valeurs desdits écarts de teinte ΔE sont indiquées dans le tableau ci-dessous.

| | Papier selon l'exemple 7 | Papier photo | Papier Sensation® | Papier Main Gloss® |
|---|---|---|---|---|
| 200°C / 5 min | ΔE = 2,2 | ΔE = 25,9 | ΔE = 8,5 | ΔE = 17,3 |
| 180°C / 5 min | ΔE = 0,6 | ΔE = 10,1 | ΔE = 5,7 | ΔE = 8,8 |
| 150°C / 5 min | ΔE = 0,2 | / | ΔE = 2,6 | ΔE = 3,1 |
| 150 °C / 1,5 min | ΔE = 0,2 | ΔE = 1,0 | ΔE = 1,7 | ΔE = 1,4 |

On remarque ainsi que, dans le cas du papier selon l'invention conforme à l'exemple 7 décrit ci-dessus, l'écart de teinte obtenu après recuit, est très faible par comparaison aux autres papiers.

Le tableau ci-dessous présente d'autres exemples comparatifs entre le papier selon l'invention, conforme à l'exemple 7, et les papiers Sensation® et Main Gloss® précités. Dans ces exemples comparatifs, on mesure la résistance R des pistes conductrices imprimées par sérigraphie ou par flexographie, ayant ensuite subi un traitement de recuit, pour chacun des papiers précités. Les valeurs desdites résistances sont indiquées dans le tableau ci-dessous.

| Type d'impression | Type de recuit | Papier selon l'exemple 7 | Papier Sensation® | Papier Main Gloss® |
|---|---|---|---|---|
| Sérigraphie encre argent Dupont 5064 | 150°C / 5 min | R = 39 Ω/sq | R = 45 Ω/sq | R = 53 Ω/sq |
| Flexographie encre argent Agfa | 180°C / 5 min | R = 1700 Ω/sq | | |
| Flexographie encre argent Agfa | 150°C / 90 s | | supérieur à 90 000 Ω/sq | supérieur à 90 000 Ω/sq |

On constate ainsi que l'utilisation du papier selon l'exemple 7 de l'invention permet de réduire la résistance des pistes conductrices imprimées, et donc d'améliorer leur conductivité électrique, par comparaison aux autres papiers du commerce.

Exemple 8 : Mise en évidence de l'influence du procédé de dépôt de la couche pigmentaire sur le substrat, sur l'état de surface du support et en conséquence sur l'adhésion de l'encre électro-conductrice.

On a comparé un support (powercoat HD 230) obtenu par le procédé décrit dans la demande de brevet WO 2013/104520 citée dans l'introduction du présent document, avec le support au sens de la présente invention.

On a fait en premier lieu un test d'adhésion de l'encre au ruban papier scotch 3M. On a utilisé :
- un ruban papier scotch 3M 2525, utilisé de façon connue pour le test d'accrochage des peintures et vernis,
- une encre Agfa Orgacon SI-P1000x imprimée en sérigraphie,
- trois supports différents.

Au moyen du support de la demande de brevet WO 2013/104520 ainsi imprimé, une partie de l'encre est arrachée par le ruban papier scotch. Avec le support de la présente invention, on n'a retrouvé aucune particule d'encre sur le ruban papier scotch. A partir d'un film PET, quelques particules d'encre restent fixées sur le ruban papier scotch

En deuxième lieu, on a fait un test d'adhésion lors d'un recuit photonique. On a utilisé une encre cuivre novacentrix ICI-021 sur presse DEK horizon 03i, et on a pratiqué un séchage à l'air libre puis un recuit photonique par lumière pulsée sur Xénon Sinteron 2000.

Sur le support de la demande de brevet WO 2013/104520, on a observé une mauvaise adhésion du cuivre lors du recuit. Il était impossible de trouver des paramètres satisfaisants. Sur le support de la présente invention, on a observé une bonne adhésion du cuivre. Sur le support PET, l'adhésion du cuivre est mauvaise et la température de réduction du cuivre (environ 500°C) fait courir un risque de déformation au PET.

On explique ces différences par la variation de microporosité de la couche pigmentaire à la surface du support, entre la demande de brevet WO 2013/104520 et la présente invention. En effet, l'utilisation d'un film plastique pour le dépôt de la couche pigmentaire à la surface du support, comme il est décrit dans la demande de brevet WO 2013/104520, induit un très grand lissé de la surface du support, et une quasi-absence de microporosité. Au contraire, l'utilisation d'un couchage au sens de la présente invention induit une microporosité suffisante pour permettre aux encres d'adhérer à la couche pigmentaire.

Afin de caractériser la microporosité de surface des supports, on a utilisé un test Microcontour® :
On a effectué le test Microcontour afin d'évaluer simplement l'état de surface d'échantillons par l'application d'une encre Bleue Microcontour Test®, Lorilleux (réf. 3811). Après avoir recouvert les deux supports précités (selon WO 2013/104520 et selon l'invention) à l'aide d'un rouleau encré, on a essuyé les deux surfaces. Cette étape permet de détecter visuellement des irrégularités sur la surface ou des défauts de couchage. Après séchage, on a effectué des mesures de densité optique à une longueur d'onde dans le visible (380-780 nm) pour quantifier l'encre restée sur le support.

Grace à cette méthode on peut très simplement avoir une idée de la rugosité et/ou de la porosité d'un support. En effet, l'encre spéciale contient des pigments d'assez grosse taille qui ne se fixent que dans les rugosités et/ou porosités importantes.

| **Densité optique** | Support WO 2013/104520 | Support selon l'invention |
|---|---|---|
| Moyenne | 0,04 | 0,61 |
| Ecart type | 0,01 | 0,061 |
| Coef. Variations | 25,0 | 10,0 |

Les résultats de ce test confirment les différences apparentes pour le support selon la demande de brevet WO 2013/104520 et le support selon l'invention : les valeurs de densités optiques entre les deux supports sont largement différentes : le papier lisse et fermé de la demande WO 2013/104520 a une très faible densité optique, car l'encre n'a pas résisté à l'essuyage. Au contraire, le support selon l'invention a une densité optique normale, car l'encre a tout de suite pénétré la surface grâce aux microporosités.

## Revendications

1. Papier comportant un substrat fibreux comprenant au moins une face recouverte d'au moins une couche, ladite couche comprenant ou consistant en :
- 100 parts en poids sec de pigments,
- de 5 à 50 parts en poids sec d'un ou plusieurs liants acryliques dont la température de transition vitreuse est inférieure ou égale à 20°C, de préférence inférieure ou égale à 10°C,
- de 0 à 15 parts en poids sec d'agent viscosant, tel par exemple que de l'alcool polyvinylique,
**caractérisé en ce que** le substrat fibreux comporte de 70 à 90 % en poids sec de fibres cellulosiques courtes, de longueur moyenne comprise dans un intervalle de 0,5 à 1,5 mm, telles que des fibres de bois, en particulier des fibres de bois issues d'une pâte chimique blanchie d'eucalyptus et 10 à 30 % en poids d'au moins une charge minérale, de préférence du carbonate de calcium, du kaolin ou du dioxyde de titane.

2. Papier selon la revendication 1, **caractérisé en ce que** ladite couche comporte de 10 à 30 parts en poids sec de liant acrylique dont la température de transition vitreuse est inférieure ou égale à 20°C, préférentiellement de 15 à 25 parts en poids sec, encore plus préférentiellement 19 parts en poids sec.

3. Papier selon la revendication 1 ou 2, **caractérisé en ce que** ladite couche comporte de 5 à 10 parts en poids sec d'alcool polyvinylique, plus préférentiellement 8 parts en poids sec.

4. Papier selon l'une quelconque des revendications 1 à 3, **caractérisé en ce que** le substrat comporte 80 % en poids sec de fibres cellulosiques courtes.

5. Papier selon l'une des revendications 1 à 4, **caractérisé en ce que** le papier a une blancheur comprise dans un intervalle de 70 à 90, de préférence comprise dans un intervalle de 75 à 85.

6. Papier selon l'une des revendications 1 à 5, **caractérisé en ce que** la différence de teinte ΔE du papier calculée à partir des coordonnées CIE LAB du papier, après un recuit à 200°C pendant 5 minutes, est inférieure à 5, de préférence inférieure à 2, par rapport audit papier avant recuit.

7. Papier selon l'une des revendications 1 à 6, **caractérisé en ce que** la couche recouvrant au moins une face est imprimée sur tout ou partie de la surface de ladite couche avec une épaisseur d'encre électro-conductrice de 0,5 à 15 µm.

8. Procédé de fabrication d'un papier selon l'une des revendications 1 à 8, **caractérisé en ce qu'**il comporte les étapes consistant à :
- former un substrat fibreux à l'aide d'une pâte fibreuse,
- recouvrir, au moins en partie, au moins une surface du substrat fibreux par couchage avec une couche comportant 100 parts en poids sec de pigments, de 5 à 50 parts en poids sec d'un ou plusieurs liants acryliques dont la température de transition vitreuse est inférieure ou égale à 20°C, de préférence est inférieure ou égale à 10°C, et de 0 à 15 parts en poids sec d'un agent viscosant,
**caractérisé en ce que** le substrat fibreux comporte de 70 à 90 % en poids sec de fibres cellulosiques courtes, de longueur moyenne comprise dans un intervalle de 0,5 à 1,5 mm, telles que des fibres de bois, en particulier des fibres de bois issues d'une pâte chimique blanchie d'eucalyptus et 10 à 30 % en poids d'au moins une charge minérale, de préférence du carbonate de calcium, du kaolin ou du dioxyde de titane.

9. Procédé selon la revendication 8, **caractérisé en ce que** le taux de raffinage de la pâte fibreuse est inférieur à 50°SR, de préférence inférieur à 40°SR, encore plus préférentiellement de l'ordre de 35°SR.

10. Procédé selon la revendication 8 ou 9, **caractérisé en ce que** ladite couche est appliquée par couchage à l'aide d'une presse encolleuse d'une machine à papier.

11. Procédé de fabrication d'un produit électro-conducteur, comportant les étapes consistant à :
- recouvrir par impression à l'aide d'une encre électro-conductrice, au moins une zone d'un support réalisé à partir d'un papier selon l'une des revendications 1 à 7,
- réaliser un recuit du support et de l'encre de façon à former une couche ou une piste continue électro-conductrice sur le support.

12. Procédé selon la revendication 11, **caractérisé en ce que** la température du recuit étant comprise dans un intervalle de 100 à 300°C, de préférence de 180 à 220 °C.

13. Procédé selon la revendication 11 ou 12, **caractérisé en ce que** la couche d'encre déposée par impression sur le support est comprise dans un intervalle de 0,5 à 15 µm, de préférence de 1 à 10 µm.

14. Procédé selon l'une des revendications 11 à 13, **caractérisé en ce que** l'encre électro-conductrice est déposée par un procédé d'impression de type sérigraphie, flexographie ou héliographie.

15. Papier comprenant un substrat fibreux comportant une face recouverte d'une couche sur laquelle est imprimée une encre électro-conductrice, tel qu'obtenu au moyen d'étapes consistant à
- former un substrat fibreux à l'aide d'une pâte fibreuse,
- recouvrir, au moins en partie, au moins une surface du substrat fibreux par couchage avec une couche comportant 100 parts en poids sec de pigments, de 5 à 50 parts en poids sec d'un ou plusieurs liants acryliques dont la température de transition vitreuse est inférieure ou égale à 20°C, de préférence est inférieure ou égale à 10°C, et de 0 à 15 parts en poids sec d'un agent viscosant,
- recouvrir par impression à l'aide d'une encre électro-conductrice, au moins une zone de la couche,
- réaliser un recuit du substrat couché et de l'encre de façon à former une couche ou une piste continue électro-conductrice sur le support, **caractérisé en ce que** le substrat fibreux comporte de 70 à 90 % en poids sec de fibres cellulosiques courtes, de longueur moyenne comprise dans un intervalle de 0,5 à 1,5 mm, telles que des fibres de bois, en particulier des fibres de bois issues d'une pâte chimique blanchie d'eucalyptus et 10 à 30 % en poids d'au moins une charge minérale, de préférence du carbonate de calcium, du kaolin ou du dioxyde de titane.

## Patentansprüche

1. Papier bestehend aus einem Fasersubstrat, bei dem mindestens einen Seite mit einer Schicht bedeckt ist, wobei sich besagte Schicht wie folgt zusammensetzt:
- 100 Teile Pigmenttrockengewicht,
- 5 bis 10 Teile Trockengewicht eines oder mehrerer Acrylbindemittel, deren Glasübergangstemperatur kleiner/gleich 20°C, vorzugsweise aber kleiner/gleich 10°C ist,
- 0 bis 15 Teile Trockengewicht eines Verdickungsmittels wie zum Beispiel Polyvinylalkohol,
**dadurch gekennzeichnet, dass** das Fasersubstrat einen Trockengewichtsanteil von 70 bis 90 % kurzer Cellulosefasern enthält, deren durchschnittliche Länge im Bereich von 0,5 bis 1,5 mm liegt, wie zum Beispiel Holzfasern, insbesondere Holzfasern, die aus gebleichtem chemischem Eukalyptus-Zellstoff stammen, und einen Gewichtsanteil von 10 bis 30 % mindestens eines mineralischen Füllstoffs, vorzugsweise Kalziumkarbonat, Kaolin oder Titandioxid.

2. Papier nach Anspruch 1, **dadurch gekennzeichnet, dass** besagte Schicht 10 bis 30 Trockengewichtsanteile Acrylbindemittel, vorzugsweise jedoch 15 bis 25 Trockengewichtsanteile und im Idealfall 19 Trockengewichtsanteile Acrylbindemittel mit einer Glasübergangstemperatur kleiner/gleich 20°C, umfasst.

3. Papier nach Anspruch 1 oder 2, **dadurch gekennzeichnet, dass** besagte Schicht 5 bis 10 Trockengewichtsanteile Polyvinylalkohol, vorzugsweise jedoch 8 Trockengewichtsanteile Polyvinylalkohol enthält.

4. Papier nach einem der Ansprüche 1 bis 3, **dadurch gekennzeichnet, dass** das Substrat einen Trockengewichtsanteil kurzer Cellulosefasern von 80 % enthält.

5. Papier nach einem der Ansprüche 1 bis 4, **dadurch gekennzeichnet, dass** das Papier eine Weiße aufweist, die in einem Bereich von 70 bis 90, vorzugsweise aber von 75 bis 85 liegt.

6. Papier nach einem der Ansprüche 1 bis 5, **dadurch gekennzeichnet, dass** der Farbunterschied ΛE des Papiers, der anhand der Koordinaten CIE LAB des Papiers berechnet wird, nach einer fünfminütigen Temperung bei 200°C im Vergleich zum Papier vor der Temperung kleiner als 5, vorzugsweise kleiner als 2 ist.

7. Papier nach einem der Ansprüche 1 bis 6, **dadurch gekennzeichnet, dass** die Schicht, die mindestens eine Seite ganz oder teilweise bedeckt, mit einer leitfähigen Farbe von 0,5 bis 15 µm bedeckt ist.

8. Herstellungsverfahren eines Papiers nach einem der Ansprüche 1 bis 8, **dadurch gekennzeichnet, dass** es aus folgenden Schritten besteht:
- der Bildung eines Fasersubstrats mithilfe eines Faserzellstoffs,
- der zumindest teilweisen Bedeckung mindestens einer Seite des Fasersubstrats durch Beschichtung mit einer Schicht bestehend aus 100 Pigmenttrockengewichtsanteilen, 5 bis 50 Trockengewichtsanteilen eines oder mehrerer Acrylbindemittel mit einer Glasübergangstemperatur kleiner/gleich 20°, vorzugsweise kleiner/gleich 10°, und 0 bis 15 Trockengewichtsanteilen eines Verdickungsmittels, **dadurch gekennzeichnet, dass** das Fasersubstrat einen Trockengewichtsanteil kurzer Cellulosefasern von 70 bis 90 % enthält, deren durchschnittliche Länge in einem Bereich von 0,5 bis 1,5 mm liegt, wie zum Beispiel Holzfasern, insbesondere Holzfasern, die aus gebleichtem chemischem Eukalyptuszellstoff stammen, und einen Trockengewichtsanteil von 10 bis 30 % mindestens einer mineralischen Füllung, vorzugsweise Kalziumkarbonat, Kaolin oder Titandioxid.

9. Verfahren nach Anspruch 8, **dadurch gekennzeichnet, dass** die Verfeinerungsrate des Faserstoffs unter 50°SR, vorzugsweise unter 40°SR und idealerweise bei 35°SR liegt.

10. Verfahren nach Anspruch 8 oder 9, **dadurch gekennzeichnet, dass** besagte Schicht mit einer Leimpresse einer Papiermaschine im Beschichtungsverfahren aufgetragen wird.

11. Herstellungsverfahren eines leitfähigen Produkts, das aus folgenden Schritten besteht:
- der Druckbeschichtung mindestens eines Bereichs eines Trägers, bestehend aus einem Papier gemäß einem der Ansprüche 1 bis 7, mit einer leitfähigen Farbe,
- der Temperung des Trägers und der Farbe, so dass eine stromleitende Schicht oder durchgängige Spur auf dem Träger gebildet wird.

12. Verfahren nach Anspruch 11, **dadurch gekennzeichnet, dass** die Temperungstemperatur in einem Bereich von 100 bis 300°C, vorzugsweise aber zwischen 180 und 200°C liegt.

13. Verfahren nach Anspruch 11 oder 12, **dadurch gekennzeichnet, dass** die auf dem Träger aufgetragene Farbschicht in einem Bereich von 0,5 bis 15 µm, vorzugsweise 1 bis 10 µm liegt.

14. Verfahren nach einem der Ansprüche 11 bis 13, **dadurch gekennzeichnet, dass** die leitfähige Farbe durch Siebdruck, Flexodruck oder Heliographie aufgetragen wird.

15. Papier bestehend aus einem Fasersubstrat, dessen eine Seite mit einer Schicht bedeckt ist, auf die eine leitfähige Farbe gedruckt wurde, die in folgenden Schritten erzielt wurde:
- der Bildung eines Fasersubstrats mit Hilfe eines Faserstoffes,
- der zumindest teilweisen Bedeckung mindestens einer Seite des Fasersubstrats im Beschichtungsverfahren mit einer Schicht, die 100 Teile Pigmenttrockengewicht, 5 bis 50 Teile Trockengewicht eines oder mehrerer Acrylbindemittel mit einer Glasübergangstemperatur kleiner/gleich 20°C bzw. vorzugsweise kleiner/gleich 10°C umfasst, und 0 bis 15 Teile Trockengewicht eines Verdickungsmittels,
- die Bedeckung mindestens eines Bereichs der Schicht mit einer leitfähigen Farbe im Druckverfahren,
- die Temperung des beschichteten Substrats und der Farbe, so dass eine leitfähige Schicht oder durchgehende Spur auf dem Träger entsteht, **dadurch gekennzeichnet, dass** das Fasersubstrat einen Trockengewichtsanteil von 70 bis 90 % kurzer Cellulosefasern enthält, deren durchschnittliche Länge in einem Bereich von 0,5 bis 1,5 mm liegt, wie zum Beispiel Holzfasern, insbesondere Holzfasern, die aus gebleichtem chemischem Eukalyptuszellstoff stammen, und einen Trockengewichtsanteil von 10 bis 30 % mindestens einer mineralischen Füllung, vorzugsweise Kalziumkarbonat, Kaolin oder Titandioxid.

## Claims

1. Paper comprising a fibrous substrate comprising at least one face covered with at least one layer, said layer comprising or consisting of:
- 100 parts by dry weight of pigments,
- 5 to 50 parts in dry weight of one or more acrylic binders whose glass transition temperature is less than equal to 20 °C, in particular less than equal to 10 °C,
- 0 to 15 parts in dry weight of viscosifying agent, such as polyvinyl alcohol,
**characterized in that** the fibrous substrate comprises 70 to 90 % in dry weight of short cellulose fibres with a mean length comprised in a range of 0.5 to 1.5 mm, such as wood fibres, in particular wood fibres obtained from a bleached chemical pulp of eucalyptus and 10 to 30 % by weight of at least one mineral filler, preferably calcium calbonate, kaolin, or titanium dioxide.

2. Paper according to claim 1, said layer comprises 10 to 30 parts in dry weight of acrylic binder whose glass transition temperature is less than or equal to 20 °C, preferably from 15 to 25 parts in dry weight, still more preferably 19 parts in dry weight.

3. Paper according to claim 1 or 2, **characterized in that** said layer comprises 5 to 10 parts in dry weight of polyvinyl alcohol, more preferably 8 parts in dry weight.

4. Paper according to any one of claims 1 to 3, caracterized in that the substrate comprises 80 % in dry weight of short cellulose fibres.

5. Paper according to any one of claims 1 to 4, caracterized in that the paper has a whiteness comprised in a range of 70 to 90, preferably in a range of 75 to 85.

6. Paper according to any one of claims 1 to 5, caracterized in that the difference in shade, ΛE, of the paper calculated from the CIE LAB coordinates oft he paper, after an annealing at 200°C for 5 minutes is less than 5, preferably less than 2, compared with said paper before annealing.

7. Paper according to any one of claims 1 to 6, caracterized in that the layer covering at least one side is printed over all or a portion of the surface of said layer with a layer of electroconductive ink having a thickness in a range of 0.5 to 15 µm.

8. Process of producing a paper according to any one of claims 1 to 8, **characterized in that** it comprises the steps consisting of:
- forming a fibrous substrate with the aid of a fibrous pulp,
- at least partially covering at least one surface of the fibrous substrate by coating with a layer comprising 100 parts in dry weight of pigments, 5 to 50 parts in dry weight of one or more acrylic binders whose glass transition temperature is less than or equal to 20°, preferably less than or eauql to 10°, and 0 to 15 parts in dry weight of a viscosifying agent,
**characterized in that** the fibrous substrate comprises 70 to 90 % in dry weight of short cellulose fibres, with a mean length comprised in a range of 0.5 and 1.5 mm, such as wood fibres, in particular wood fibres obtained from a bleached chemical pulp of eucalyptus and 10 to 30 % by weight of at least one mineral filler, preferably calcium calbonate, kaolin, or titanium dioxide.

9. Process according to claim 8, **characterized in that** the degree of refining of the fibrous pulp is less than 50°SR, preferably less than 40°SR, still more preferably in the ordre of 35°SR.

10. Method according to claim 8 or 9, **characterized in that** said layer is applied by coating with a aid of a size press of a paper machine.

11. Process for the production of an electroconductive product, comprising the steps consisting of:
- covering, by printing using an electroconductive ink, at least one zone of a support produced from a paper as claimed in one of claims 1 to 7,
- annealing the support and the ink so as to form an electroconductive layer or continuous track on the support.

12. Process according to claim 11, **characterized in that** the annealing temperature is comprised in a range of 100°C to 300°C, preferably in the range of 180 to 200°C.

13. Process according to claim 11 or 12, **characterized in that** a thickness of an ink layer deposited by printing on the support is comprised in a range of 0.5 to 15 µm, preferably in a range of 1 to 10 µm.

14. Process according to any one of claims 11 to 13, **characterized in that** the electroconductive ink is deposited using a screen printing, flexographic or heliographic type printing process.

15. Paper comprising a fibrous substrate comprising a side covered with a layer onto which an electroconductive ink is printed, obtained by means of steps consisting of:
- forming a fibrous substrate with the aid of a fibrous pulp,
- at least partially covering at least one surface of the fibrous substrate by coating with a layer comprising 100 parts in dry weight of pigments, 5 to 50 parts in dry weight of one or more binders whose glass transition temperature is less than or equal to 20°C, in particular less than or equal to 10°C, and 0 to 15 parts in dry weight of a viscosifying agent,
- covering at least one zone of the layer by printing using an electroconductive ink,
- annealing the coated substrate and the ink so as to form an electroconductive layer or continuous track on the support, **characterized in that** the fibrous substrate comprises 70 to 90 % in dry weight of short cellulose fibres with a mean length comprised in a range of 0.5 to 1.5 mm, such as wood fibres, in particular wood fibres obtained from a bleached chemical pulp of eucalyptus and 10 to 30 % by weight of at least one mineral filler, preferably calcium calbonate, kaolin, or titanium dioxide.
